**Europäisches Patentamt**

(19) **European Patent Office**

**Office européen des brevets**

(11) Numéro de publication : **0 258 075 B1**

(12) # FASCICULE DE BREVET EUROPEEN

(45) Date de publication du fascicule du brevet :
**25.09.91 Bulletin 91/39**

(51) Int. Cl.⁵ : **G11C 11/34**

(21) Numéro de dépôt : **87401534.0**

(22) Date de dépôt : **01.07.87**

(54) **Mémoire vive statique du type MOS et son procédé de mémorisation.**

(30) Priorité : **30.07.86 FR 8611029**

(43) Date de publication de la demande :
**02.03.88 Bulletin 88/09**

(45) Mention de la délivrance du brevet :
**25.09.91 Bulletin 91/39**

(84) Etats contractants désignés :
**BE CH DE ES FR GB IT LI NL SE**

(56) Documents cités :
**US-A- 3 974 486**
**US-A- 4 142 111**

(73) Titulaire : **BULL S.A.**
**121 avenue de Malakoff P.B. 193.16**
**F-75764 Paris Cédex 16 (FR)**

(72) Inventeur : **Boudou, Alain**
**121, avenue de Malakoff**
**F-75764 Paris Cédex 16 (FR)**
Inventeur : **Doyle, Brian**
**121, avenue de Malakoff**
**F-75764 ParisCédex 16 (FR)**

(74) Mandataire : **Denis, Hervé et al**
**BULL S.A. Industrial Property Department**
**P.C.: HQ 8M006 P.B. 193.16 121 avenue de**
**Malakoff**
**F-75764 Paris Cédex 16 (FR)**

# Description

L'invention se rapporte à un procédé de mémorisation d'un bit d'information dans une cellule de mémoire vive statique intégrée du type MOS, au transistor MOS pour la mise en oeuvre du procédé, et à la mémoire vive statique intégrée en résultant.

Une mémoire intégrée est une mémoire formée sur une plaquette semiconductrice couramment appelée circuit intégré, puce ou chip. Une mémoire se présente sous la forme d'une matrice de cellules connectées à une grille de fils orthogonaux. Parmi ces fils se trouve généralement un ensemble de fils orthogonaux servant à l'adressage de chaque cellule. L'adressage d'une cellule se fait par deux décodeurs désignant respectivement deux fils orthogonaux représentatifs de la rangée et de la colonne auxquelles la cellule est connectée.

L'invention concerne les mémoires vives, dites encore mémoires RAM (Random Access Memory). Dans ces mémoires, une information peut être écrite ou lue à volonté. Par conséquent, en plus des fils d'adressage, il existe un ensemble de fils orthogonaux permettant respectivement de stocker un bit d'information dans chacune des cellules et de lire le contenu de chaque cellule. Ces fils sont connectés à une logique de commande soumise à l'action d'un signal de commande CS et d'un signal R/W qui ordonne selon son état la lecture ou l'écriture d'une donnée. Cette logique comporte une entrée pour la donnée à écrire dans la mémoire et une sortie pour la donnée lue dans la mémoire. L'information contenue dans une mémoire vive est totalement perdue en cas de disparition de la tension d'alimentation.

Dans la famille des mémoires vives, on distingue les mémoires dynamiques des mémoires statiques. L'invention se rapporte aux mémoires statiques de type MOS, dans lesquelles chaque cellule contient une bascule bistable faite à partir de transistors à effet de champ de type MOS (Métal Oxyde Semiconducteur). Les deux états de la bascule représentent respectivement les deux valeurs "0" et "1" d'un bit d'information.

Un avantage des mémoires vives statiques est de pouvoir commuter rapidement d'un état à l'autre. Cependant, l'inconvénient majeur des mémoires vives statiques réside dans la grande surface requise pour la réalisation d'une cellule. Jusqu'à présent, la constitution d'une bascule bistable nécessite deux transistors MOS pourvus chacun d'une résistance de charge. Il faut encore y ajouter deux transistors d'adressage, dont la conduction indique que la cellule a été sélectionnée. L'encombrement de chaque cellule ne pouvait donc être réduit qu'en diminuant les dimensions géométriques des transistors et en les assemblant judicieusement.

L'objectif principal de l'invention est de permettre la haute intégration des cellules dans une mémoire vive statique intégrée, grâce à l'emploi d'un nombre restreint de transistors pour constituer chaque cellule.

Le procédé conforme à l'invention de mémorisation d'un bit d'information dans une cellule de mémoire vive statique de type MOS est caractérisé en ce qu'il consiste à doper le canal d'un transistor MOS de la cellule de façon à faire apparaître un phénomène d'hystérésis en régime de conduction sous le seuil du transistor MOS, et à utiliser un cycle d'hystérésis pour écrire et lire le bit d'information dans ce transistor.

En corollaire, une mémoire vive statique intégrée du type MOS conforme à l'invention est caractérisée en ce qu'au moins une cellule inclut comme élément de mémorisation un transistor MOS présentant un phénomène d'hystérésis en régime de conduction sous le seuil.

Les caractéristiques et avantages de l'invention ressortiront de la description qui suit, donnée à titre d'exemple et faite en référence aux dessins annexés.

Dans les dessins :

– la figure 1 est une vue en coupe schématique d'une mémoire vive statique intégrée au niveau d'un transistor MOS conforme à l'invention ;

– la figure 2 est un graphe à échelles linéaires illustrant une courbe caractéristique de l'intensité du courant drain-source Ids en fonction de la tension grille-source Vgs pour une valeur paramétrique prédéterminée de la tension drain-source Vds appliquée sur un transistor MOS classique ;

– la figure 3 est un graphe illustrant des courbes caractéristiques du courant drain-source Ids en fonction de la tension drain-source Vds appliquée sur un transistor MOS conforme à l'invention ;

– la figure 4 est une vue de détail agrandi du graphe de la figure 3 de façon à faire ressortir l'effet d'hystérésis de la conduction sous le seuil d'un transistor MOS conforme à l'invention ;

– la figure 5 est un graphe à échelle semilogarithmique illustrant des courbes caractéristiques du courant drain-source Ids en fonction de la tension grille-source Vgs appliquée sur un transistor conforme à l'invention en conduction sous le seuil ;

– la figure 6 est un graphe illustrant la résistance négative correspondant à l'effet d'hystérésis représenté sur les figures 4 et 5 ;

– la figure 7 illustre schématiquement une structure de cellule d'une mémoire vive statique intégrée conforme à l'invention ; et

– la figure 8 est un graphe illustrant le fonctionnement du transistor de mémorisation conforme à l'invention contenu dans la cellule représentée sur la figure 7.

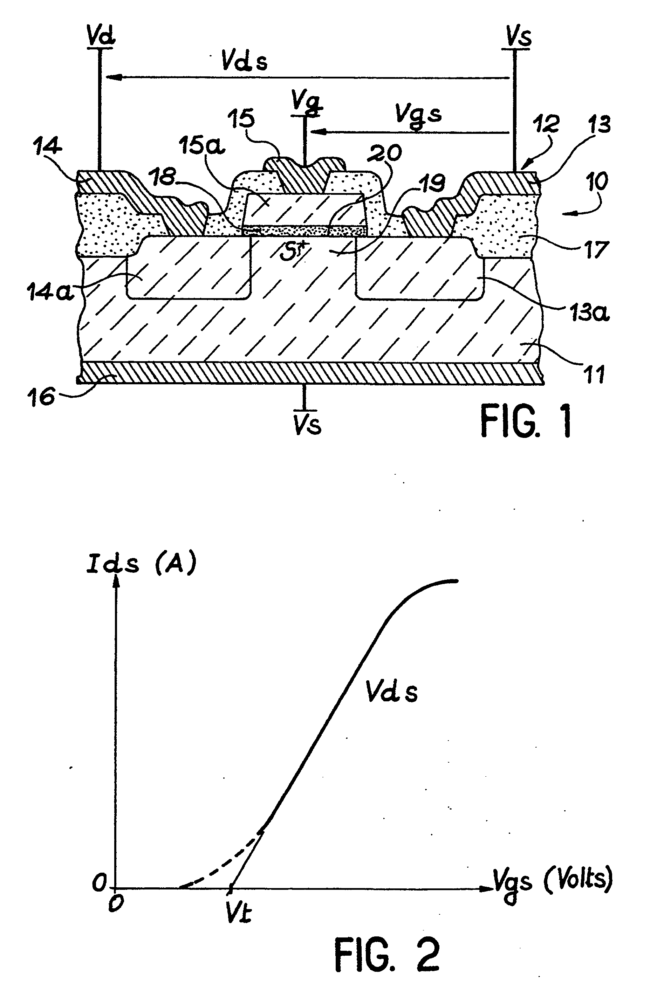

La figure 1 est une vue partielle d'une mémoire vive statique (10) intégrée dans un substrat semiconducteur de silicium (11). Le substrat (11) est représenté en coupe transversale au niveau d'un transistor MOS (12) conforme à l'invention. Le transistor (12) a la structure d'un transistor MOS ordinaire, pourvu de quatre électrodes, respectivement de source (13), de drain (14), de grille (15) et de substrat (16). Le substrat (11) incorpore la région de source (13a) et la région de drain (14a) du transistor et porte une couche diélectrique (17). Les électrodes de source (13), de drain (14) et de grille (15) sont des couches conductrices formées au-dessus du substrat (11) et traversant la couche diélectrique (17) pour être respectivement en contact avec la région de source (13a), la région de drain (14a) et la grille (15a) du transistor. La grille (15a) est placée sur une couche diélectrique mince d'oxyde de grille (18) reposant sur le substrat (11) entre les deux régions de source et de drain (13a), (14a) et formant avec le substrat une interface (20). La couche diélectrique mince (18) est généralement du dioxyde de silicium (SiO2), tandis que la grille (15a) peut être du silicium polycristallin fortement dopé, du métal, ou une combinaison des deux. Le canal (19) du transistor est la région du substrat (11) située entre les régions de source et de drain (13a), (14a) et sous-jacente à la couche d'oxyde de grille (18). Enfin , l'électrode de substrat (16) illustrée recouvre la face arrière du substrat (11). L'électrode de substrat (16) pourrait aussi être une région surdopée du même type de conductivité que le substrat (11) et accessible par une électrode de surface placée à l'extérieur de l'aire occupée par le transistor (12). Le transistor (12) peut être du type N-MOS ou P-MOS. De façon typique, le transistor (12) en condition de fonctionnement a son électrode de drain (14) à la tension (Vd), son électrode de grille (15) à la tension (Vg), tandis que ses électrodes de source (13) et de substrat (16) peuvent être connectées à une même tension, dite tension de source (Vs), comme illustré. La tension de source (Vs) sert ordinairement de référence pour les tensions de drain et de grille.

Les résultats expérimentaux indiqués dans les graphes annexés ont été obtenus d'un transistor (12) ayant les caractéristiques suivantes. Il appartenait à la famille des transistors courts. Sachant que les longueurs se mesurent suivant la direction du courant qui circule dans le transistor, on appelle communément un transistor court un transistor dont la grille géométrique (dessinée) est inférieure à environ 5 micromètres (5 µm). En pratique, la grille (15a) avait une longueur géométrique de 2,5 µm. La couche d'oxyde de grille (18) avait une épaisseur de 70 nm (nanomètres). Le substrat (11) était de type P et avait une résistivité de 18 ohm.cm. Les régions de source et de drain (13a, 14a) étaient de type N et avaient une épaisseur de 400 nm. Le substrat avait subi un recuit à 1050°C pendant 30 minutes et n'avait reçu ni implantation d'ajustement de seuil (threshold implantation) ni implantation contre l'effet de perçage (punchthrough implantation). Les caractéristiques d'un transistor conforme à l'invention ressortiront clairement après la présentation et la discussion des résultats des mesures décrites dans les graphes qui suivent.

Auparavant, les caractéristiques de fonctionnement d'un transistor MOS classique seront rappelées en référence à la figure 2. La figure 2 est un graphe à échelles linéaires, qui illustre une courbe caractéristique de l'intensité Ids du courant drain-source en fonction de la tension grille-source Vgs appliquée sur un transistor MOS classique, du type N-MOS comme le transistor (12) expérimental. Les tensions de grille Vgs appliquées ordinairement sur un transistor classique sont positives. La courbe caractéristique illustrée correspond à une valeur paramétrique prédéterminée de la tension drain-source Vds. Les courbes caractéristiques correspondant à d'autres valeurs paramétriques ont approximativement la même forme que la courbe illustrée. La partie continue de la courbe illustrée se rapporte au régime de conduction normale du transistor. Cette partie est essentiellement linéaire et ne s'incurve que pour les hautes valeurs de Vgs. Le prolongement de la partie linéaire coupe l'axe des tensions Vgs en un point qui définit la tension de seuil Vt du transistor. La partie linéaire du régime de conduction normale vérifie l'équation Ids = B (Vgs-Vt) Vds, où B est le coefficient de transconductance du transistor. La partie tiretée de la courbe représente le régime de la conduction sous le seuil du transistor MOS. Cette partie correspond à des valeurs de tension de grille Vgs inférieures à la tension de seuil Vt et obéit à l'équation approchée des transistors courts N-MOS : Ids = Io exp [(Vgs/a)+(Vds/d)], où a et d sont des coefficients prédéterminés.

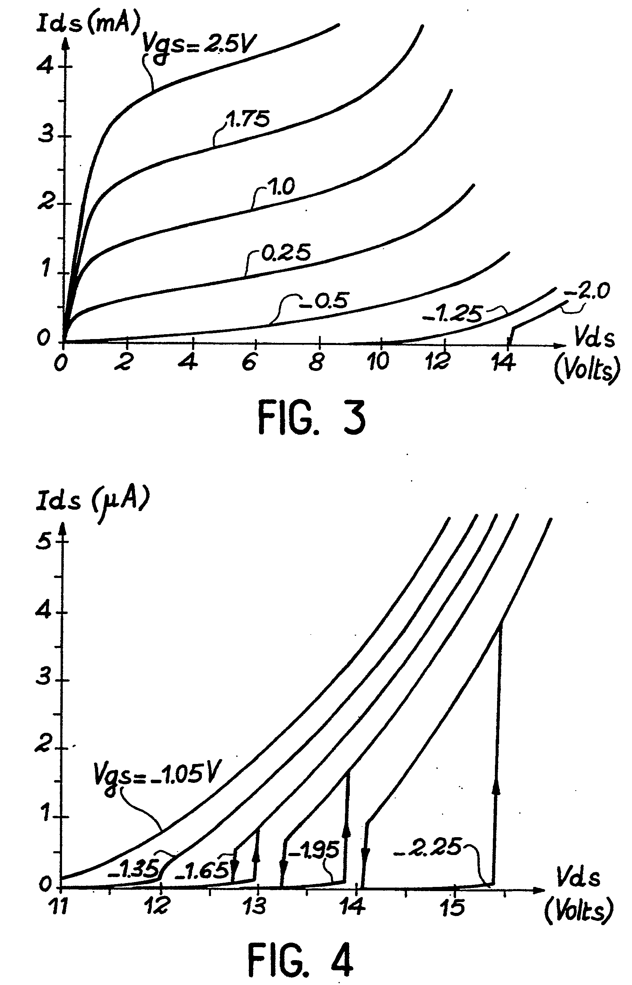

La figure 3 est un graphe illustrant des courbes caractéristiques de conduction d'un transistor MOS conforme à l'invention tel que le transistor (12) représenté sur la figure 1 et réalisé dans les conditions expérimentales précitées. Dans ces conditions, la tension de seuil Vt est approximativement zéro Volt. Le graphe illustre les variations de l'intensité Ids du courant circulant entre le drain et la source du transistor (12) en fonction de la tension Vds entre les électrodes de drain et de source (14, 13) pour diverses valeurs paramétriques de la tension grille-source Vgs.

D'une manière générale, les courbes partent toutes en fait du point d'origine (Vds = 0 et Ids = 0). Puisque Vt = 0 Volt, les courbes représentatives de la conduction normale du transistor (12) sont obtenues pour des valeurs positives de Vgs. Elles correspondent ainsi à la partie continue de la courbe du graphe de la figure 2 dans laquelle la tension de seuil Vt serait nulle. Les courbes correspondantes qui sont illustrées dans la figure 3 sont typiquement celles d'un transistor MOS court classique. Elles s'établissent toutes à un palier sensiblement horizontal, légèrement croissant (courbes de type pentode). Pour des valeurs plus élevées de Vds, l'intensité Ids a tendance à croître selon une pente nettement accentuée, que l'on doit limiter pour éviter la destruction du transistor par effet d'avalanche.

Le graphe de la figure 3 présente aussi des courbes correspondant à la conduction sous le seuil du transistor (12) et obtenues dans les conditions précédentes lorsque la tension de grille Vgs est négative. Les courbes correspondant à Vgs = - 0,5 V et - 1,25 V ne présentent plus le palier des courbes précédentes et sont appelées par conséquent courbes de type triode. Ces courbes sont bien connues et correspondent au régime de la conduction sous le seuil Vt d'un transistor MOS court classique, telle qu'illustrée par la partie discontinue de la courbe du graphe de la figure 2.

En résumé, l'ensemble des courbes illustrées se référant à une tension de grille Vgs comprise entre + 2,5 V et - 1,5 V sont connues comme courbes typiques de fonctionnement d'un transistor court, dont le dopage du canal n'est pas optimisé. En effet la résistivité du canal (19) du transistor (12) est celle du substrat (11), soit 18 ohm.cm dans l'exemple choisi. Dans ces conditions, les courbes du type pentode et triode représentées sur la figure 3 sont considérées comme inappropriées au fonctionnement normal requis pour un transistor. C'est pourquoi un tel transistor ne se présente pas dans les circuits électroniques du commerce. Ceux-ci incluent des transistors dont le dopage du canal a été optimisé selon des procédés bien connus pour obtenir les courbes caractéristiques typiques requises. Par conséquent, un transistor (12) à dopage de canal non optimisé n'a pas fait jusqu'à présent l'objet d'études particulières sur son fonctionnement. L'invention qui va maintenant être exposée est le résultat d'une telle étude.

Le graphe de la figure 3 illustre de façon rudimentaire le domaine de l'invention par la courbe correspondant à Vgs = - 2,0 Volts. On voit en effet que cette courbe présente une discontinuité dans la région des hautes tensions de drain Vds (14 Volts environ). D'une manière générale, le domaine de l'invention est celui, dans le régime de la conduction sous le seuil du transistor (12), qui fait apparaître de telles discontinuités. Ce domaine est illustré en détail dans le graphe de la figure 4. Ce graphe est similaire à celui de la figure 3, mais illustre plus précisément des courbes correspondant à la conduction sous le seuil du transistor (12) dans la région des hautes tensions de drain Vds. Les courbes illustrées ont été obtenues en augmentant lentement la tension de drain Vds de 11 à 16 Volts, puis en revenant lentement à 11 Volts. Pour la tension de grille Vgs = - 1,05 Volt, la courbe ne présente aucune discontinuité et correspond à l'état normal de la conduction sous seuil d'un transistor MOS court tel qu'illustré par la partie discontinue de la courbe de la figure 2. Pour Vgs = - 1,35 V, on observe un coude à Vds = 12 Volts qui indique une anomalie dans le régime bien connu de la conduction sous seuil. Pour Vgs = - 1,65 V, on observe un net effet d'hystérésis. En faisant croître la tension de drain, il apparaît une discontinuité pour Vds = 13 V, alors que la discontinuité ne se produit qu'au retour pour Vds = 12,7 V. Les courbes montrent que l'effet d'hystérésis s'amplifie au fur et à mesure que la tension de grille diminue. Ainsi, pour Vgs = - 2,25 V, les deux discontinuités sont séparées d'environ 1,3 V. Pour des tensions de grille plus basses, l'effet d'hystérésis disparaît lors du balayage aller lorsque le transistor entre dans la région de claquage source-drain par avalanche.

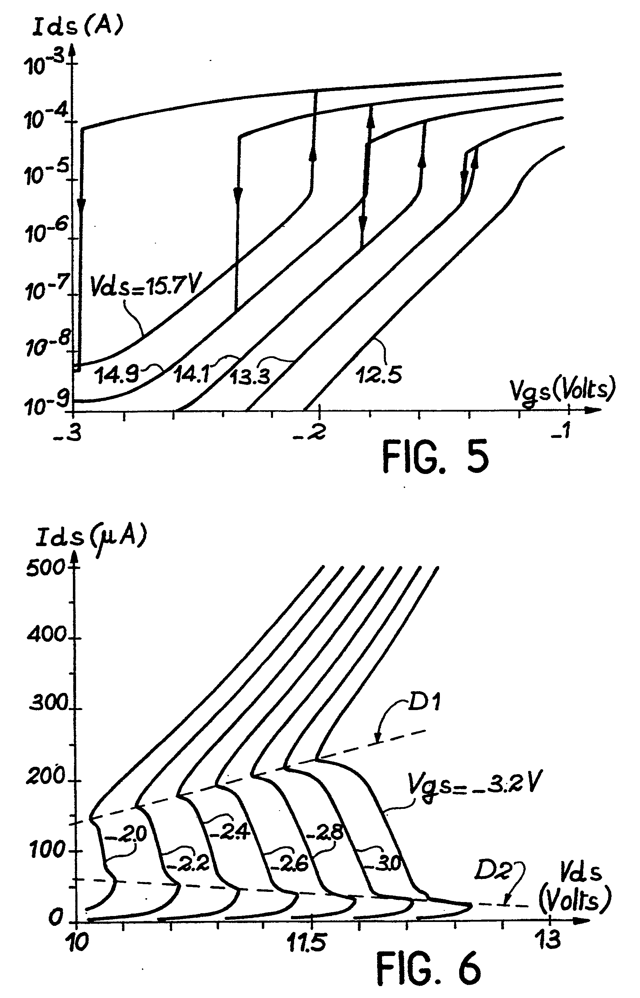

Le graphe de la figure 5 illustre des courbes représentatives des variations de l'intensité Ids du courant drain-source en fonction de la tension de grille Vgs pour diverses valeurs paramétriques de la tension de drain Vds appliquée sur le transistor (12) dans le domaine de l'invention correspondant au graphe de la figure 4. Autrement dit, la figure 5 est une vue de détail agrandi du graphe de la figure 2 dans la région représentative du régime de conduction sous le seuil d'un transistor MOS conforme à l'invention. Cependant, le graphe de la figure 5 est semilogarithmique de façon à tenir compte des larges variations du courant Ids (du nanoampère au milliampère) lorsque la tension de grille Vgs varie selon une échelle linéaire de - 1 à - 3 V. La courbe correspondant aux faibles tensions de drain (Vds = 12,5 V) ne présente pas de discontinuité et correspond ainsi au régime bien connu de la conduction sous le seuil d'un transistor MOS classique, tel qu'illustré par la partie tiretée de la courbe de la figure 2. La variation exponentielle du courant s'exprime logiquement dans le graphe semilogaritmique de la figure 5 par la partie linéaire de la courbe obtenue pour Vds = 12,5 V. Un effet d'hystérésis est observé pour Vds = 13,3 V. Les deux discontinuités sont cependant très voisines. L'effet d'hystérésis est net pour Vds = 14,1 V et s'amplifie lorsque la tension de drain croît. Pour Vds = 15,7 V, les deux discontinuités sont séparées d'un volt. On observera que les parties linéaires correspondant aux faibles courants (moins d'un microampère environ) correspondent à la conduction sous le seuil bien connue, similaire à celle de la courbe relative à Vds = 12,5 V. Pour les intensités supérieures, le courant après commutation varie selon une loi parabolique, comme cela ressort également de la figure 3. Ce type de variation correspond à un régime de courant limité par la charge d'espace.

L'effet d'hystérésis d'un transistor en régime de conduction sous le seuil s'explique de la façon suivante. Cette explication permettra de définir les conditions nécessaires pour l'obtention d'un transistor conforme à l'invention. Aux hautes tensions de drain Vds pour lesquelles l'effet d'hystérésis se produit, une ionisation par impact près de la région de drain (14a) crée dans cette région des paires électron-trou. Les trous créés par avalanche sont accélérés vers les zones de faible potentiel, c'est-à-dire vers la source (13) et l'électrode de substrat (16), ainsi que vers l'interface (20) lorsque la tension de grille Vgs est négative. Dans ce dernier cas, le courant par trous qui va jusqu'à l'électrode de substrat (16) n'est pas suffisant pour dépolariser la jonction du substrat (11) avec la région de source (13) et aboutir dans un transistor court à un claquage par résistance négative (snap-back breakdown).

Dans un transistor ayant une grille courte (15a) posée sur un substrat (11) faiblement dopé, la distribution du potentiel dans le substrat fait apparaître un point selle S situé sous l'interface (20) à une profondeur comprise entre 0,1 et 0,3 micromètre. Ceci est décrit par exemple dans l'article de Toyabe et al. dans la revue IEEE Transactions on Electron Devices, 1979, ED-26, page 453-461 et intitulé "Analytical Models of Threshold Voltage and Breakdown Voltage of Short Channel MOSFET's Derived from Two-Dimensional Analysis".

Dans une distribution en forme de selle, le point à potentiel minimal dans un plan correspond à un potentiel maximal dans un plan orthogonal. C'est par ce point selle que le courant drain-source Ids passe dans les conditions décrites ci-dessus. Les trous qui s'accumulent à l'interface (20) pendant une courte échelle de temps modifient la distribution de potentiel à l'intérieur du substrat (11) et font par conséquent varier la valeur du potentiel au point selle S par rapport à celle de l'interface (20). Les trous accumulés à l'interface (20) fuient eux aussi vers l'électrode de substrat par le point selle S et, dans l'état stationnaire, sont remplacés en quantité égale par des trous produits par avalanche issus de la région de drain (14a). L'abaissement de la barrière de potentiel au point selle correspond à la charge stationnaire au niveau de l'interface (20). Cependant, au point de commutation lors du balayage aller (point d'amorçage), le courant qui charge l'interface (20) est toujours plus grand que le courant de fuite, si bien qu'on ne peut plus avoir un état stationnaire. Il s'ensuit un abaissement du potentiel au niveau du point selle, qui accroît le courant par électrons entre drain et source. L'accroissement du courant par électrons crée par avalanche un plus grand nombre de trous et charge donc de plus en plus l'interface (20). Ceci aboutit à une rétroaction positive, qui se traduit par une résistance négative dans les caractéristiques représentées sur les figures 4 et 5. La figure 6 illustre ce fait par un graphe représentant les variations du courant Ids en fonction de la tension de drain Vds pour diverses valeurs de la tension de grille Vgs lorsque le transistor (12) est commandé en courant. Les parties de courbes comprises entre les lignes D1 et D2 traduisent l'existence de la résistance négative. Cet état continue jusqu'à ce que le courant devienne suffisamment grand pour que la concentration des porteurs équilibre la concentration des dopants. Le transistor entre alors dans le régime de courant limité par la charge d'espace. Dans ce régime, la charge d'espace limite elle-même toute modification ultérieure de la distribution des potentiels.

Au retour du cycle, le régime reste limité par la charge d'espace lorsque la tension décroît, jusqu'à ce que le courant drain-source Ids atteigne un point où la densité des porteurs mobiles est égale à la densité des porteurs fixes. Alors le régime de courant limité par la charge d'espace ne peut plus être maintenu. Le transistor (1.2) retombe dans un régime classique de courant sous le seuil.

Ces explications mettent en relief l'importance de la position du point selle pour créer l'effet d'hystérésis révélé par l'invention. Elles ont montré que le phénomène d'hystérésis est dû à un dopage particulier du substrat, non optimisé par rapport au dopage des transistors MOS classiques. Plus précisément, il faut que le dopage soit suffisamment faible pour qu'il existe un point selle S placé juste sous l'interface (20), mais il ne doit pas être trop faible pour être masqué par un régime de courant limité par la charge d'espace (lequel régime s'établit aux faibles valeurs du courant). Dans l'exemple illustré, on a vu que le dopage donnait au substrat la résistivité 18 ohm.cm qui révèle que le substrat n'a pas été fortement dopé par rapport au dopage ordinaire des transistors classiques. Par ailleurs, la théorie actuelle laisse supposer que l'effet d'hystérésis ne se produirait que dans les transistors courts. Selon la théorie également, toute implantation contre l'effet de perçage (punchthrough implantation) rendrait difficile l'existence d'un phénomène d'hystérésis.

En résumé, un phénomène d'hystérésis se produit en régime de la conduction sous le seuil d'un transistor MOS dont le substrat a été faiblement dopé pour qu'il existe un point selle S placé juste sous l'interface (20), sans être trop faible pour éviter un masquage par le régime de courant limité par charge d'espace qui s'établit aux faibles valeurs de courant.

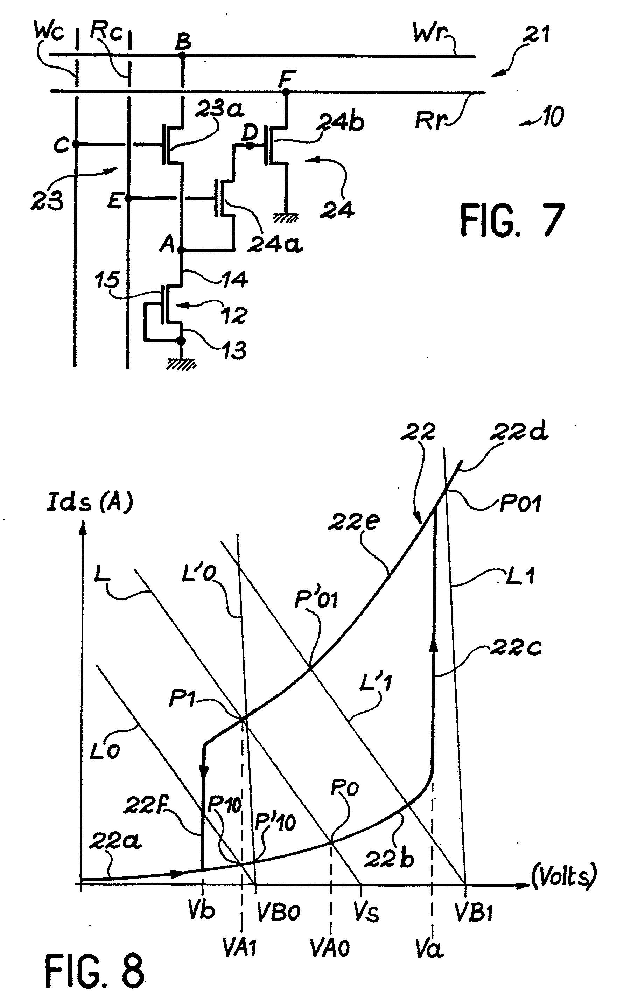

Le phénomène d'hystérésis est généralement exploité pour constituer un élément de mémoire d'un bit d'information. Les deux états stables de l'élément, qui sont obtenus au cours d'un cycle d'hystérésis, représentent respectivement les deux valeurs binaires "0" et "1" du bit d'information. Par conséquent, un transistor (12) présentant un phénomène d'hystérésis peut avantageusement constituer à lui seul un point de mémoire dans chaque cellule d'une mémoire intégrée sur une pastille semiconductrice telle que la mémoire (10) de la figure 1. Comme le transistor peut passer d'un état à l'autre en fonction de sa polarisation, la mémoire (10) est du type mémoire vive ou RAM. Comme toute mémoire vive classique, la mémoire (10) conforme à l'invention perd son information en l'absence de tension d'alimentation. D'autre part, la mémoire vive (10) conforme à l'invention est du type statique, puisque la mémorisation ne fait pas intervenir de condensateurs comme dans la famille des mémoires dynamiques. Autrement dit, dans chaque cellule d'une mémoire statique intégrée, un seul transistor et sa résistance de charge peuvent remplacer la bascule bistable classique à deux transistors MOS et à deux résistances de charge. La figure 7 illustre un exemple de réalisation d'une cellule de mémoire (21) faisant intervenir le transistor (12) dans la mémoire vive statique intégrée (10) conforme à l'invention. La figure 8 illustre le fonctionnement de la cellule (21) représentée sur la figure 7.

Dans la cellule (21) représentée sur la figure 7, le transistor (12) est supposé avoir la courbe caractéristique (22) tracée en trait fort sur la figure 8. La courbe (22) présente la commutation à l'aller pour la tension Vds = Va et la commutation de retour pour Vds = Vb. Pour des raisons de commodité, la courbe (22) présente les parties suivantes : 22a est la partie qui va de 0 Volt à Vb, 22b va de Vb à Va, 22c est le front de commutation aller, 22d correspond aux tensions Vds > Va, 22e est au retour la partie comprise entre Va et Vb, et 22f est le front de commutation au retour. La cellule de mémoire (21) représentée sur la figure 7 comprend le transistor (12), un dispositif d'écriture (23) et un dispositif de lecture (24). Le transistor (12) a ses électrodes de grille (15) et de source (13) mises à la masse et a son électrode de drain (14) connectée à un point A. Le dispositif d'écriture (23) illustré sert aussi de résistance de charge du transistor (12). Ainsi, le dispositif d'écriture (23) dans la cellule (21) est établi entre le point A, un fil d'écriture rangée Wr et un fil d'écriture colonne Wc. Le dispositif d'écriture (23) comprend un transistor (23a), dont la source est connectée au point A, le drain est connecté sur le fil Wr au point B, et la grille est connectée sur le fil Wc au point C. Le dispositif de lecture (24) de la cellule (21) est monté entre le point A, un fil de lecture rangée Rr et un fil de lecture colonne Rc, et comprend deux transistors (24a) et (24b). Le transistor (24a) a sa source connectée au point A, son drain connecté au point D commun avec la grille du transistor (24b), et sa grille est connectée au point E sur la ligne Rc. Le transistor (24b) a sa source mise à la masse et son drain connecté au point F sur le fil Rr. Il est clair que les quatre fils (Wr, Rr ; Wc, Rc) s'étendent tout au long de la mémoire intégrée (10) pour desservir respectivement les cellules de la même rangée et de la même colonne que la cellule (21). Il a été dit précédemment que tous les fils relatifs aux rangées et aux colonnes sont rattachés à une logique de commande, non illustrée. "

Le fonctionnement de la cellule (21) va maintenant être décrit en référence à la figure 8. On appelera VA, VB,..., VF les états logiques respectifs des points A, B,..., F. On notera VA0 la tension au point A lorsque VA = 0, VA1 la tension au point A lorsque VA = 1, VBO la tension au point B lorsque VB = 0, etc... A l'état initial, le transistor (12) de chaque cellule est polarisé par l'application de tensions de polarisation prédéterminées aux points B et C du transistor (23a) pour être placé dans l'un des états de repos correspondant aux états logiques "0" et "1". Le transistor (23a) constitue la charge du transistor (12) conforme à l'invention. La caractéristique de charge du transistor (23a) dans les conditions de fonctionnement conformes à l'invention du transistor (12) est approximativement une droite L telle qu'illustrée à la figure 8. Initialement, on supposera que pour une tension de repos VB = Vs, la droite L est placée de manière que le point de polarisation du transistor (12) soit placé au repos au point P0 dans le segment (22b) de la courbe caractéristique (22) de ce transistor. Par convention, on supposera aussi que cet état du transistor correspond à l'état logique "0", de sorte que la tension Vds du transistor (12) est VA0 correspondant à VA = 0. De même, on dira que pour l'état logique "0", VC = 0. Avantageusement, le transistor (23a) sera du type à déplétion de façon que l'état VC = 0 corresponde approximativement à VCO = 0 Volt.

Supposons maintenant que l'on veuille écrire dans la cellule (21) le bit d'information "1". Cet état correspond à l'autre état stable du transistor (12) et nécessite par conséquent de déclencher l'amorçage du cycle d'hystérésis de ce transistor. On voit sur la figure 8 qu'il est alors nécessaire d'élever la tension Vds du transistor (12). Par conséquent, on applique aux points B et C des surtensions correspondandant à l'état logique "1", de sorte que VB = 1 et VC = 1. La valeur VB1 de la tension relative à VB = 1 est nécessairement supérieure à la tension d'amorçage Va et déplace ainsi la droite de charge L de Vs à VB1. D'autre part, la surtension correspondant au changement d'état logique du point C fait changer la pente de la droite de charge L. Il en résulte une droite de charge L1, qui coupe en P01 le segment 22d de la courbe caractéristique (22) du transistor (12). La polarisation du transistor est ainsi passée du point P0 sur le segment 22b correspondant à l'état logique "0" au point P01 situé après l'amorçage de l'hystérésis et correspondant à l'état logique "1". De cet état transitoire, on revient à l'état de repos correspondant à la droite de charge L. En faisant d'abord VB = 1 et VC = 0, la droite de charge L1 devient L'1, qui reprend la pente de la droite L et fait descendre le point de polarisation P01 au point P'01 sur le segment 22e de la courbe caractéristique (22) du transistor (12). P'01 étant situé en deçà du front de descente 22f du cycle d'hystérésis, l'état du transistor est encore celui correspondant à l'état logique "1". Le retour à l'état de repos VB = Vs et VC = 0 translate la droite de charge L'1 en L, qui coupe le segment 22e en P1 pour lequel le transistor se stabilise à l'état logique "1" (VA =1).

Si maintenant on veut réécrire un bit d'information "0" dans la cellule (21), on voit à la figure 8 que la polarisation du transistor (12) doit franchir le front de descente (22f) du cycle d'hystérésis (22). Ceci oblige à abaisser la tension VA. Pour ce faire, on laisse VC = 0 et on abaisse en conséquence la tension VB à une valeur VBO correspondant à l'état logique "0" (VB = 0). Il en résulte une translation de la droite de charge L à une position L0 pour laquelle la polarisation du transistor (12) franchit le front de retour (22f) du gicle d'hystérésis (22). La polarisation du transistor vient donc s'établir à un état stable intermédiaire P10. Le point P10 est ici situé sur le segment (22b) pour lequel l'état logique du transistor est "0". On notera que si l'état du point C devient VC = 1, la droite L0 pivote autour du point VBO pour se placer en une position L'0 parallèle à la droite L1. Le point de polarisation P10 se déplace sur le segment (22b) pour se fixer en P'10 correspondant toujours à l'état logique "0" du transistor (12). Le retour à l'état de repos (VB = Vs et VC = 0) correspond à la droite de charge L, qui place la polarisation du transistor (12) au point P0 relatif à l'état logique "0" (VA = 0). En résumé, l'écriture d'un bit d'information dans le transistor (12) de la cellule (21) se fait pour les états VB = 1, VC = 1 et VB = 0, VC =0. On a vu d'autre part que les autres états VB = 0, VC = 1 et VB = 1, VC = 0 ne modifient pas l'état du transistor (12). En d'autres termes, en plus de la fonction d'écriture, le transistor (23a) peut servir à l'adressage de la cellule (21).

La lecture du bit d'information contenu dans le transistor (12) de la cellule (21) fait intervenir les fils Rc et Rr et les transistors (24a) et (24b). Les points concernés sont A, D, E, F.

Si VA = 1, la conduction du transistor (24a) fait que VD1 = VA1 - V't, où V't est la tension de seuil du transistor (24a). En ajustant le seuil de déclenchement de la conduction du transistor (24b) à une tension supérieure à VD1, ce transistor reste bloqué et maintient l'état VF = 1.

Par contre, si VA = 0, le transistor (24a) conduit et donne VD0 = VA0 - V't. En ajustant le seuil de déclenchement du transistor (24b) à une tension inférieure à VD0, ce transistor est alors passant et fait passer l'état logique de la ligne Rr de 1 à 0. En résumé, en mettant un "1" logique sur les fils Rr et Rc, l'absence de transistion indique la présence d'un "1" logique dans le transistor (12) (VA = 1), tandis qu'une transition indique que le transistor (12) est à l'état logique "0" (VA = 0).

De préférence, le seuil de déclenchement du transistor (24b) a la valeur moyenne de VD1 et VD0. D'autre part, il est à noter que l'emploi du transistor (24b) est facultatif. Il est avantageux de l'incorporer pour accélérer la décharge de la ligne Rr. En effet, on voit que la conduction du transistor (24b) décharge directement la ligne Rr. Autrement, en l'absence de transistor (24b) (D = F) la décharge de la ligne Rr devrait se faire à travers le transistor (24a) et le transistor (12). Etant donné la forte valeur capacitive de la ligne Rr et les faibles intensités du courant de décharge dans le transistor (12), le temps de décharge serait nettement plus long.

## Revendications

1. Procédé de mémorisation d'un bit d'information dans une cellule (21) de mémoire vive statique de type MOS, caractérisé en ce qu'il consiste à doper le canal (19) d'un transistor MOS (12) de la cellule de façon à faire apparaître un phénomène d'hystérésis en régime de conduction sous le seuil du transistor MOS, et à utiliser un cycle d'hystérésis pour écrire et lire le bit d'information dans le transistor.

2. Procédé selon la revendication 1, caractérisé en ce que le dopage est suffisamment faible pour qu'il existe un point selle S placé juste sous l'interface (20) entre le canal (19) et la couche d'oxyde de grille (18), sans être trop faible pour éviter un masquage par le régime de courant limité par charge d'espace qui s'établit aux faibles valeurs de courant.

3. Mémoire vive statique intégrée du type MOS (10), caractérisée en ce qu'au moins une cellule (21) inclut comme élément de mémorisation un transistor MOS (12) présentant un phénomène d'hystérésis en régime de conduction sous le seuil.

4. Mémoire selon la revendication 3, caractérisée en ce que le transistor (12) comporte une résistance de charge (23a).

5. Mémoire selon la revendication 4, caractérisée en ce que la résistance de charge (23a) est un transistor MOS.

6. Mémoire selon la revendication 5, caractérisée en ce que le transistor de charge (23a) constitue le dispositif d'écriture (23) de la cellule (21).

7. Mémoire selon la revendication 5 ou 6, caractérisée en ce que le transistor de charge (23a) constitue le dispositif d'adressage de la cellule (21).

8. Mémoire selon l'une des revendications 5 à 7, caractérisée en ce que le transistor de charge (23a) est du type à déplétion, dont la tension de grille présente un état logique (VC = 0) pour une valeur VCO de 0 Volt environ.

9. Mémoire selon l'une des revendications 3 à 8, caractérisée en ce que le dispositif de lecture (24) de la cellule (21) comprend un transistor MOS (24a) connecté entre le drain du transistor de mémorisation (12) et un fil de lecture (Rr) de la mémoire.

10. Mémoire selon la revendication 9, caractérisée en ce que le dispositif de lecture (24) comporte un second transistor MOS (24b) destiné à accélérer la décharge dudit fil de lecture (Rr).

## Patentansprüche

1. Verfahren zum Speichern eines Informationsbits in einer Zelle (21) eines statischen flüchtigen Speichers vom MOS-Typ, dadurch gekennzeichnet, daß es die Dotierung des Kanals (19) eines-MOS-Transistors (12) der Zelle, derart, daß im Leitungsbereich unter der Durchlaßschwelle des . MOS-Transistors ein Hysterese-Phänomen auftritt, und die Verwendung eines Hysterese-Zyklus zum Schreiben und zum Lesen des Informationsbits im Transistor umfaßt.

2. Verfahren gemäß Anspruch 1, dadurch gekennzeichnet, daß die Dotierung ausreichend gering ist, damit ein Sattelpunkt S vorliegt, der sich direkt unter der Grenzfläche (20) zwischen dem Kanal (19) und der Gate-Oxidschicht (18) befindet, ohne zu schwach zu sein, um eine Abdeckung durch den Strombereich, der durch die bei geringen Stromwerten auftretende Raumladung begrenzt wird, zu vermeiden.

3. Integrierter, statischer flüchtiger Speicher vom MOS-Typ (10), dadurch gekennzeichnet, daß wenigstens eine Zelle (21) als Speicherzelle einen MOS-Transsistor enthält, der im Bereich unterhalb der Durchlaßgrenze (12) ein Hysterese-Phänomen aufweist.

4. Speicher gemäß Anspruch 3, dadurch gekennzeichnet, daß der Transistor (12) einen Lastwiderstand (23a) aufweist.

5. Speicher gemäß Anspruch 4, dadurch gekennzeichnet, daß der Lastwiderstand (23a) ein MOS-Transistor ist.

6. Speicher gemäß Anspruch 5, dadurch gekennzeichnet, daß der Lasttransistor (23a) die Schreibeinrichtung (23) der Zelle (21) bildet.

7. Speicher gemäß Anspruch 5 oder 6, dadurch gekennzeichnet, daß der Lasttransistor (23a) die Adressierungseinrichtung der Zelle (21) bildet.

8. Speicher gemäß einem der Ansprüche 5 bis 7, dadurch gekennzeichnet, daß der Lasttransistor (23a) vom Verarmungstyp ist, dessen Gatespannung einen logischen Zustand (VC = 0) für einen Wert VCO von ungefähr 0 Volt aufweist.

9. Speicher gemäß einem der Ansprüche 3 bis 8, dadurch gekennzeichnet, daß die Leseeinrichtung (24) der Zelle (21) einen MOS-Transistor umfaßt, der zwischen den Drain des Speicher-transistors (12) und einen Lesedraht (Rr) des Speichers geschaltet ist.

10. Speicher gemäß Anspruch 9, dadurch gekennzeichnet, daß die Leseeinrichtung (24) einen zweiten MOS-Transistor (24b) aufweist, der zur Beschleunigung der Entladung des Lesedrahts (Rr) bestimmt ist.

a hysteresis phenomenon with conduction below the threshold of the MOS transistor, and utilizing a hysteresis cycle for writing and reading the data bit in the transistor.

2. A method according to claim 1, characterized in that the doping is sufficiently weak that a saddle point S exists, located just below the interface (20) between the channel (19) and the gate oxide layer (18), without being too weak, to prevent a masking by the rate of the space-charge-limited current that is established at low current values.

3. An integrated MOS-type static random access memory (10), characterized in that at least one cell (21) includes, as its memorizing element, an MOS transistor (12) having a hysteresis phenomenon with subthreshold conduction.

4. A memory according to claim 3, characterized in that the transistor (12) includes a load resistor (23a).

5. A memory according to claim 4, characterized in that the load resistor (23a) is an MOS transistor.

6. A memory according to claim 5, characterized in that the load transistor (23a) comprises the writing device (23) of the cell (21).

7. A memory according to claim 5 or 6, characterized in that the load transistor (23a) comprises the addressing device of the cell (21).

8. A memory according to one of claims 5 to 7, characterized in that the load transistor (23a) is of the depletion type, the gate voltage of which has a logic state (VC = 0) for a value VCO of approximately 0 volts.

9. A memory according to one of claims 3 to 8, characterized in that the reading device (24) of the cell (21) includes an MOS transistor (24a) connected between the drain of the memorizing transistor (12) and a reading wire (Rr) of the memory.

10. A memory according to claim 9, characterized in that the reading device (24) includes a second MOS transistor (24b) intended to accelerate the discharge of said reading wire (Rr).

## Claims

1. A method for memorizing a data bit in an MOS-type static random access memory cell, characterized in that it comprises doping the channel (19) of an MOS transistor (12) of the cell in such a way as to produce

FIG. 1

FIG. 2

FIG. 3

FIG. 4

FIG. 5

FIG. 6

FIG. 7

FIG. 8